# EUROPÄISCHE PATENTSCHRIFT

(11) **EP 1 196 952 B1**
(45) Veröffentlichungstag und Bekanntmachung des Hinweises auf die Patenterteilung: **29.10.2008**
(21) Anmeldenummer: 00938809.1
(22) Anmeldetag: 21.06.2000
(51) Int. Cl.: H01L 27/146, H01L 31/02, H01L 31/0203

(54) **DETEKTORMODUL FÜR RÖNTGENDETEKTORSYSTEM**
DETECTOR MODULE FOR AN X-RAY DETECTOR SYSTEM
MODULE DETECTEUR POUR SYSTEME DETECTEUR DE RAYONS X

(30) Priorität: 21.06.1999 DE 19929567
(43) Veröffentlichungstag der Anmeldung: 17.04.2002
(73) Patentinhaber: Deutsches Elektronen-Synchrotron DESY, 22603 Hamburg (DE)
(72) Erfinder: HANSEN, Karsten, D-22549 Hamburg (DE); TRÖGER, Larc, D-22765 Hamburg (DE)
(74) Vertreter: UEXKÜLL & STOLBERG
(86) Internationale Anmeldenummer: PCT/EP2000/005758
(87) Internationale Veröffentlichungsnummer: WO 2000/079598

(56) Entgegenhaltungen:
- US-A- 5 041 729
- US-A- 5 464 984
- US-A- 5 777 335

## Beschreibung

Die Erfindung betrifft allgemein ein Detektormodul für ein Röntgendetektorsystem zur Verwendung bei Röntgenholographie und Röntgenspektroskopie mit atomarer Auflösung sowie ein modular aufgebautes Röntgendetektorsystem für obige Anwendungen, bei dem solche Detektormodule Verwendung finden.

Seit der Erfindung der Holographie im Jahre 1948 wird an der räumlichen Darstellung atomarer Strukturen nach dem Holographie-Prinzip gearbeitet. Ein mögliches Lösungsprinzip basiert auf der Technik der Röntgen-Holographie.

Bei der Röntgen-Holographie werden Atome in einer zu untersuchenden Materialprobe zur Fluoreszenz angeregt, und die Fluoreszenzstrahlung, die von der Materialprobe ausgeht, wird von einem Detektor erfaßt. Die elektrischen Ausgangssignale des Detektors, die das sich aufbauende Interferenzfeld innerhalb der Materialprobe widerspiegeln, geben dann Aufschluß über die räumliche Struktur des untersuchten Proben-Materials. Hierzu ist es allerdings erforderlich, daß an der Materialprobe eine möglichst große Anzahl von Messungen durchgeführt wird.

In den vergangenen Jahren wurden deutliche Fortschritte bei der Entwicklung und Fertigung von Röntgendetektoren erzielt, die die Fluoreszenzstrahlung der Materialprobe aufnehmen und diese zuverlässig von der vielfältigen Hintergrundstrahlung trennen sollen. Diese Detektoren müssen einerseits energieempfindlich sein, um eine Unterscheidung der einfallenden Photonen nach ihrer Energie bzw. der Wellenlänge der Strahlung zu ermöglichen, andererseits aber den Betrieb bis zu so hohen Zählraten ermöglichen, daß sie einige hunderttausend Photonen pro Sekunde aufnehmen. Für diesen Zweck wurden in der Vergangenheit neben Silizium-Detektoren zumeist Germanium-Detektoren verwendet. Letztere müssen jedoch mit flüssigem Stickstoff gekühlt werden, was relativ aufwendig ist, und sind bevorzugt zur Strahlungserfassung ab etwa 10 keV geeignet. Ein weiterer Nachteil bei der Verwendung von Germanium-Detektoren besteht darin, daß die Elektronik zum Verstärken der von dem Germanium-Detektor ausgehenden Meßsignale nur an einer Stelle angeordnet werden kann, die von dem Germanium-Detektor relativ weit entfernt ist. Deshalb sind zur Kopplung des Germanium-Detektors mit der Verstärker-Elektronik lange Verbindungsleitungen erforderlich, was zu starken Störungen und zu einer hohen Fehleranfälligkeit führt. Eine Integration von Vorverstärkerstufen in der Nähe des Germanium-Detektors ist bisher nicht zufriedenstellend gelungen, wobei die aufwendige Kühlung des Germanium-Detektors ein wesentliches Hindernis darstellt. Außerdem muß bei einer Integration der Verstärker-Elektronik in der Nähe der Germanium-Detektoren eine größere Anzahl von Signalleitungen von dem Germanium-Detektor bzw. von der Verstärker-Elektronik weggeführt werden, was sich selbst bei kleineren Detektor-Zeilen oder Detektor-Arrays als ein nicht zu lösendes Hindernis dargestellt hat.

In der jüngsten Vergangenheit wurden auch bei der Entwicklung und Fertigung von orts- und energieauflösenden Silizium-Röntgendetektoren Fortschritte erzielt. So gelang beispielsweise die monolithische Integration hochempfindlicher Driftdetektorzellen mit Feldeffekttransistoren auf der Basis hochohmiger Siliziumsubstrate. Dieser Detektortyp wurde als einzelliger Detektor bereits auf dem Gebiet der Röntgen-Holographie genutzt.

Wie vorstehend erwähnt, ist es für die Röntgen-Holographie erforderlich, daß eine möglichst große Anzahl von Messungen der Materialprobe durchführt wird. In einem der möglichen konkreten Meßverfahren (Meßverfahren 1) bedeutet das, daß oberhalb der Materialprobe über dem Raumwinkelbereich einer Halbkugel oberhalb der Materialprobe mit einer Winkelauflösung im Grad-Bereich eine große Anzahl von Messungen der Fluoreszenzstrahlung der Probe durchgeführt wird. Bei diesen Messungen ist es bei der Verwendung von einzelligen Detektoren notwendig, den Detektor mittels einer mechanisch aufwendigen und teuren Verfahr-Konstruktion schrittweise entlang verschiedener Bahnen auf der halbkugelförmigen Fläche oberhalb der Materialprobe zu verlagern. Um die charakteristischen Linien innerhalb des Spektrums mit der erforderlichen Genauigkeit nachweisen zu können, sind zum Beispiel etwa 2·10⁶ Einträge pro Raumwinkelelement notwendig. Bis zu einer Ereignisrate von etwa 150 kHz lassen sich die Linien ohne größere Beeinträchtigung ihrer Breite bestimmen. Da für ein vollständiges Hologramm zum Beispiel 7200 Aufnahmen unter verschiedenen Raumwinkeln notwendig sein können, ergibt sich eine Gesamt-Meßzeit von etwa 24 Stunden.

In einem zweiten konkreten Meßverfahren (Meßverfahren 2) der Röntgen-Holographie wird die nötige Winkelauflösung durch verschiedene Einfallswinkel von monochromatischem Röntgenlicht erreicht. Eine Winkelauflösung der Fluoreszenzsztahlung der Probe und damit ein Verfahren des Detektors ist dabei nicht erforderlich. Aufgrund der oben erwähnten Ereignisraten-Limitierung von einzelligen Detektoren ergibt sich dieselbe Gesamt-Meßzeit.

Es ist möglich, die lange Gesamt-Meßzeit zu verkürzen, indem statt eines einzelligen Detektors mehrzellige Detektoren verwendet werden. Durch gleichzeitige Messung verschiedener Winkelbereiche (Meßverfahren 1) bzw. der bei mehrzelligen Detektoren entsprechend vervielfachten Ereignisrate (Meßverfahren 2) vermindert sich die die Gesamt-Meßzeit um etwa den Faktor der Zahl der Detektorelemente. Aufgrund der limitierten Zahl von Zellen bzw. Elementen erübrigen alle kommerziellen mehrzelligen Germanium-Detektoren weder aufwendige Verfahrkonstruktionen im Meßverfahren 1, noch ermöglichen sie nur eine Meßzeitreduzierung auf weniger als etwa eine Stunde (beide Meßverfahren). Diese Meßzeitreduzierung wird als nicht ausreichend angesehen, da sowohl (Synchrotron)strahlungsquellen als auch die Detektoren beim Langzeitbetrieb Schwankungen unterworfen sind. Auch die Materialprobe selbst kann sich während dieser langen Messung verändern, weshalb idealerweise Echtzeit-Aufnahmen gewünscht sind.

Neben dem hier detaillierter dargestellten Beispiel der Röntgen-Holographie sind Detektoren für Röntgenstrahlung in einer Vielzahl anderer Meßmethoden im Einsatz, zum Beispiel in der Röntgenabsorptionsspektroskopie, der Röntgenbeugung, der Röntgenfluoreszenzanalyse und vielen anderen Feldern mehr. Aus vergleichbaren Gründen, wie den oben erwähnten, limitieren kommerzielle Silizium- und Germanium-Detektoren die Messungen in vielen Anwendungen (zum Beispiel an Synchrotronstrahlungsquellen) aufgrund der maximal möglichen Ereignisrate der Detektoren oder der erreichbaren Winkel- oder Ortsauflösung.

In der US 5,041,729 ist ein mehrzelliger Strahlungsdetektor offenbart, bei dem eine Anzahl von Detektorelementen in Form einer Zeile angeordnet ist. Der Strahlungsdetektor enthält einen Szintillator, an dessen Rückseite 12 streifenförmige Photodioden in Form einer Zeile nebeneinander angeordnet sind. An den Photodioden ist mittels eines isolierenden Klebstoffs eine Halterung angebracht, so daß alle 12 Photodioden abgedeckt werden und ein Endabschnitt einer jeden Photodiode zur Verdrahtung freiliegt. Die Halterung besteht aus einem keramischen Isolator und ist auf ihrer Rückseite mit Signalleitungen für jedes Element ausgebildet. Die Bond-Anschlußfläche einer jeden Photodiode ist durch eine Drahtbondung mit den Signalleitungen verbunden. Der Nachteil dieser Ausgestaltung besteht darin, daß lediglich eine Detektorzeile - nicht aber ein Detektorarray - hergestellt werden kann, da die Art der Verdrahtung ausschließlich eine zeilenförmige Anordnung der Detektorelemente zuläßt. Bei Verwendung einer Detektorzeile ist jedoch eine sehr lange Meßzeit erforderlich. Außerdem muß die Detektorzeile mit Hilfe einer mechanisch aufwendigen und teuren Verfahr-Konstruktion schrittweise verlagert werden, um eine Gesamtaufnahme durchzuführen.

Weitere Detektormodule werden in US-A-5 464 984 und US-A-5 777 335 offenbart.

Es ist daher Aufgabe der Erfindung, ein Detektorsystem vorzusehen, mit Hilfe dessen die vorstehend genannten Nachteile des Standes der Technik überwunden werden. Es ist insbesondere Aufgabe der vorliegenden Erfindung, ein Detektormodul mit einer zweidimensionalen Anordnung von Detektorelementen zu einem Detektorarray einschließlich der entsprechenden Verdrahtungstechnik vorzusehen, wobei mit Hilfe eines solchen Detektormoduls über eine Orts- bzw. Winkelauflösung die simultane Erfassung von Röntgenlicht möglich ist, so daß sich zum Beispiel bei der Röntgen-Holographie die sonst üblichen Verfahr-Konstruktion erübrigt. Eine weitere Aufgabe der Erfindung besteht darin, eine hohe Gesamtereignisrate des Detektorsystems zu ermöglichen, so daß die Meßzeit bei gleicher Qualität der Meßergebnisse deutlich reduziert wird, bzw. bei gleicher Meßzeit die Qualität der Meßergebnisse erhöht wird.

Zur Lösung dieser Aufgaben dient ein Detektormodul mit den Merkmalen von Patentanspruch 1 sowie ein aus solchen Detektormodulen aufgebautes Detektorsystem mit den Merkmalen von Patentanspruch 26. Vorteilhafte Ausgestaltungen des Detektormoduls bzw. des Detektorsystems sind Gegenstand der zugehörigen Unteransprüche.

Der Grundgedanke der vorliegenden Erfindung besteht darin, mehrere, jeweils eine Anzahl von Detektorelementen enthaltende Detektormodule etwa in Form einer Halbkugel um die zu untersuchende Materialprobe herum anzuordnen. Aufgrund einer solchen Detektoranordnung sind bedeutend geringere Meßzeiten und sogar die Erzeugung von Echtzeit-Bildern möglich.

Diese Anordnung von Detektorelementen führt jedoch aufgrund der hohen erforderlichen Dichte der Detektorelemente zu Folgeproblemen bezüglich der Kontaktierung der Detektorelemente und der Kühlung der Detektormodule bzw. der zugehörigen Signalverarbeitungselektronik. Bei dem erfindungsgemäßen Detektormodul werden Detektorzellen verwendet, die auf dem Siliziumsubstrat mit einer integrierten Vorverstärkerelektronik versehen sind. Dadurch vermindert sich zwar die Länge der Signalleitungswege zwischen dem Detektorelement und der Vorverstärkerstufe, was zu einer beträchtlichen Verminderung von Störungen führt; gleichzeitig erhöht sich aber die Anzahl der Signalleitungen, die von der Detektorelement/Vorverstärker-Anordnung weggeführt werden müssen.

Die Anordnung der Detektormodule lehnt sich vorzugsweise an die gekappte Ikosaeder-Struktur der C₆₀-Fullerene (Bucky-Ball) an, wobei (ähnlich wie bei einem Fußball) durch zehn hexagonale Detektormodule ein inneres Grundgerüst in Form einer Halbkugel gebildet wird, dessen fünf pentagonale Lücken zwischen den hexagonalen Detektormodulen durch fünf weitere Detektormodule ausgefüllt werden. Dabei können in die pentagonalen Lücken entweder pentagonale Detektormodule eingesetzt, oder, was aus Kostengründen bevorzugt ist, die pentagonalen Lücken durch identische hexagonale Detektormodule überdeckt werden.

Bei einer bevorzugten Ausgestaltung beträgt der Radius der Halbkugel ca. 3,7 cm. Bei dieser Ausgestaltung sind insgesamt etwa 900 einzelne Detektorelemente vorgesehen, wodurch eine Raumwinkelauflösung von etwa 4° erreicht wird. Bei der gekappten Ikosaeder-Struktur werden insgesamt 15 Detektormodule benötigt, wobei jedes Detektormodul etwa 60 Detektorelemente trägt. Als Detektortyp werden Silizium-Detektoren verwendet, bei denen im Gegensatz zu den bekannten Germanium-Detektoren ein Betrieb bei Raumtemperatur möglich ist. Silizium-Detektoren sind Germanium-Detektoren bei niedrigen und mittleren Energien und hohen Zählraten in der Auflösung überlegen. Jedoch hat jedes Silizium-Detektorelement (bedingt durch den darin integrierten Transistor) eine Leistungsaufnahme von bis zu etwa 4 mW, so daß sich daraus eine Leistungsdichte von bis zu etwa 80 mW/cm² ergibt. Daraus wird deutlich, daß trotz der Verwendung von Silizium-Detektoren Maßnahmen zur Kühlung der Detektorelemente bzw. der Detektormodule erforderlich sind (konventionelle Luft-, Wasser- oder Peltier-Kühlung).

Wie vorstehend erläutert, enthält jedes Detektormodul vorzugsweise etwa 60 Detektorelemente, die in flächiger, nebeneinanderliegender Anordnung ein Detektorarray bilden, das im wesentlichen die gleiche sechseckige Grundform wie das eigentliche Detektormodul hat. Aufgrund der notwendigen, parasitätsarmen Ankopplung der Signalverarbeitungselektronik zur Verarbeitung der von den einzelnen Detektorelementen (hochempfindliche Driftdetektorzellen, die monolithisch mit Feldeffekttransistoren integriert sind) ausgehenden Analogsignale muß diese Signalverarbeitungselektronik in der Nähe der Detektorelemente bzw. des Detektorarrays integriert werden. Wegen der geringeren Eigenerwärmung der einzelnen Detektorelemente und der deutlich höheren Verlustleistungsaufnahme der Komponenten der Signalverarbeitungselektronik ist eine thermische Entkopplung zwischen der Signalverarbeitungselektronik und dem Detektorarray sowie eine Kühlung bzw. eine gute Wärmeableitung entsprechender Wärmeströme erforderlich. Eine gute Wärmeableitung wird dadurch erreicht, daß Gehäuseteile des Modulkörpers aus einem Material mit guten Wärmeleiteigenschaften bestehen, vorzugsweise Graphit. Eine thermische Entkopplung beider Wärmequellen wird dadurch erzielt, daß Wärmeströme der beider Wärmequellen möglichst kurze gemeinsame Pfade nehmen. Die Auswahl geeigneter Materialien und Querschnitte zwischen Wärmequellen und Wärmesenke richtet sich nach den jeweiligen Beträgen der Wärmeströme.

Die ortsnahe Integration bzw. parasitätsarmen Ankopplung der Signalverarbeitungselektronik an das Detektorarray erfolgt vorzugsweise mit Hilfe eines Leiterbahnträgers, der direkt über dem Detektorarray angeordnet ist. Auf diesem Leiterbahnträger müßte theoretisch für jeden Anschluß von jedem Detektorelement eine Leiterbahn vorgesehen sein, wobei jede Leiterbahn einen ersten Endkontakt in direkter Nähe zu dem jeweiligen Detektoranschluß, um mit diesem durch einen Bonddraht verbunden zu werden, und einen zweiten Endkontakt hat, der sich an einer Endkante des Leiterbahnträgers befindet, um von dort mit der Elektronik verbunden zu werden.

Bei der elektrischen Kontaktierung der einzelnen Silizium-Detektorelemente wären für jedes Detektorelement in der hier vorgestellten Ausbildung mit integriertem Feldeffekttransistor insgesamt 6 Anschlüsse zu kontaktieren und mit sehr kurzen Bonddrahtlängen mit dem über den Detektorelementen angeordneten Leiterbahnträger zu verbinden. Bei einer sensitiven Fläche von etwa 5 mm² für jedes Detektorelement ist eine Kontaktierung mit konventioneller Drahtbondtechnik nicht möglich. Auch würden sich die auf dem Leiterbahnträger dicht nebeneinanderliegenden Leiterbahnen gegenseitig beeinflussen, was zu einer starken Beeinträchtigung der Meßergebnisse führen würde. Dieses Problem wird erfindungsgemäß dadurch gelöst, daß einige Anschlüsse der Detektorelemente, vorzugsweise die empfindlichen Signalleiteranschlüsse vorzugsweise jeweils zusammen mit einem konstantspannungsführenden Anschluß, durch Bonddrähte mit dem Leiterbahnträger bzw. mit den jeweils ersten Endkontakten der auf dem Leiterbahnträger vorgesehenen Leiterbahnen verbunden werden. Die übrigen Anschlüsse der Detektorelemente werden mit Hilfe von einfachen Kettenbondverbindungen an eine äußere, an den Außenkanten des Detektorarrays ringartig verlaufende Busstruktur angeschlossen und über Bonddrähte durch zusätzliche Bohrungen im Randbereich des Leiterbahnträgers mit auf dem Leiterbahnträger vorgesehenen Leiterbahnen verbunden. Dadurch wird die Anzahl der Bondverbindungen, die durch Bohrungen in dem Leiterbahnträger geführt werden müssen, und auch die Anzahl der Leiterbahnen deutlich vermindert. Um die unerwünschte gegenseitige Kopplung der auf dem Leiterbahnträger nebeneinander angeordneten Leiterbahnen zu reduzieren, werden die Leiterbahnen, die mit den obigen konstantspannungsführenden Anschlüssen verbunden sind, auf dem Leiterbahnträger jeweils zwischen zwei nebeneinander verlaufenden Signalleiterbahnen geführt.

Die Kopplung zwischen Signalleitungen ist ganz wesentlich durch die Dielektrizitätskonstante des Trägermaterials bestimmt. Keramische Materialien, wie Al₂O₃ oder auch AlN, weisen eine um etwa den Faktor 3 höhere Dielektrizitätskonstante auf als zum Beispiel Polymere. Daher ist zwischen dem mechanisch stabilen Trägermaterial mit höherer Dielektrizitätskonstante und der signalführenden Metallisierungsebene vorzugsweise eine Zwischenschicht mit einer deutlich kleineren Dielektrizitätskonstanten eingebettet. Die Dicke dieser Zwischenschicht sollte etwa der Breite einer signalführenden Leiterbahn entsprechen. Als Material für die Zwischenschicht bieten sich besonders Benzocyclobutene oder auch Polyphenylquinoxaline mit einer relativen Dielektrizitätskonstanten von ca. 2,7 an, aber auch Standard-Polyimide wären denkbar. Eine weitere Optimierung ergibt sich daraus, die in der Metallisierungsebene befindlichen Abschirm-Leiterbahnen (detaillierte Erläuterung folgt) an gleicher Stelle auch in einer zweiten Metallisierungsebene zwischen dem steifen Träger und der dielektrischen Zwischenschicht vorzusehen. Im Vergleich zu der einfachsten Lösung, bei der die Signalleitungen direkt auf einem keramischen Träger ausgebildet sind, kann die Koppelkapazität gerade bei kleinen Abständen zwischen den Signalleitungen (zum Beispiel ca. 50 µm bei Leiterbahnbreiten von ca. 15µm) um mehr als den Faktor 30 reduziert werden.

Wie eingangs erwähnt, besteht der Grundgedanke der Erfindung darin, mehrere, jeweils eine Anzahl von Detektorelementen enthaltende Detektorarrays bzw. Detektormodule etwa in Form einer Halbkugel um die zu untersuchende Materialprobe herum anzuordnen. Vorzugsweise ist die Halbkugelfläche durch eine Anordnung aus mehreren flächigen Detektormodulen aufgebaut, die jeweils mehrere Detektorelemente enthalten. Dabei sind die einzelnen Detektormodule vorzugsweise so geformt und angeordnet, daß eine möglichst lückenlose Abdeckung der Halbkugelfläche erreicht wird. Bevorzugt ist dabei die Verwendung von möglichst wenigen verschiedenen Modulformen. Eine mögliche Variante besteht darin, vier Sechsecke und fünf Vierecke zu einem Tetrakaidekaeder zusammenzufügen. Eine weitere bevorzugte Variante besteht darin, eine gekappte Ikosaeder-Struktur der C₆₀-Fullerene (Bucky-Balls) zu verwenden, bei der eine etwa halbkugelförmige Fläche aus zehn Sechsecken gebildet ist, deren fünf fünfeckige Freiflächen entweder durch passend eingefügte Fünfecke geschlossen oder durch gleiche Sechsecke überdeckt werden. Bei beiden beispielhaft genannten Varianten ist es bevorzugt, die Halbkugelfläche aus identischen Detektormodulen aufzubauen, weshalb die viereckigen Freiflächen des Tetrakaidekaeders bzw. die fünfeckigen Freiflächen der Ikosaeder-Struktur jeweils durch die sechseckigen Basismodule überdeckt werden, wodurch bei beiden Varianten nur ein einziger Modultyp (ein sechseckiges Detektormodul) erforderlich ist. Zur besseren Anpassung an die Halbkugelfläche ist es natürlich auch möglich, gekrümmte Detektormodule zu verwenden.

Bei einer bevorzugten Ausgestaltung der Erfindung wird die vorstehend genannte Ikosaeder-Struktur verwendet, bei der sich die Verbindungen zwischen den einzelnen Detektorelementen und der nachgeschalteten Signalverarbeitungselektronik (Analogverstärker usw.) sehr kurz halten lassen, um auf diese Weise parasitäre Effekte zu vermindern. Der oder die Chips, die die Signalverarbeitungselektronik enthalten, sind vorzugsweise über dem Detektormodul angeordnet und gegenüber dem Detektorarray strahlungstechnisch abgeschirmt. Die Verbindungen zwischen den Anschlüssen der Detektorelemente eines Detektorarrays mit den Anschlüssen der Chips der Signalverarbeitungselektronik werden mit Hilfe eines biegsames Flachkabels bzw. einer flexiblen Anschlußfolie hergestellt, das nahe einer Seitenkante des sechseckigen Detektormoduls herausgeführt wird.

Wie bereits vorstehend erläutert, hat das bevorzugte Detektormodul eine sechseckige Form und enthält ca. 61 angeschlossene Detektorelemente. Die äußere Kantenlänge des bevorzugten Moduls beträgt etwa 1,5 cm, und die aktive Fläche beträgt etwa 3 cm². Das Verhältnis von aktiver zu passiver Fläche beträgt etwa 50 %, wobei dieses Verhältnis von der verwendeten Bondtechnik abhängig ist. Bei der sogenannten Flip-Chip-Kontaktierung kann ein Verhältnis von aktiver zu passiver Fläche von etwa 90 % erreicht werden. Bei der Flip-Chip-Kontaktierung können Probleme wegen der unterschiedlichen Wärmeausdehnungskoeffizienten von AlN (Leiterbahnträger) und Si (Detektorarray) auftreten. Eine mögliche Lösung stellt die Verwendung von Silizium auch für den Leiterbahnträger dar, wobei dann beispielsweise eine Polymerschicht als Dielektikum verwendet werden kann.

Bei einem bevorzugten Kugelradius der Bucky-Ball-Anordnung von etwa 3,7 cm ergibt sich eine mittlere Raumwinkelauflösung von etwa 4°. Dabei ist offensichtlich, daß sich die Raumwinkelauflösung unter Beibehaltung der Detektorelement-Flächendichte durch Erhöhung des Halbkugelradius steigern läßt. Hierbei steigt jedoch gleichzeitig auch die Gesamtanzahl der Detektorelemente und folglich auch der technische Aufwand, der zur Verarbeitung der Vielzahl von Datenkanälen erforderlich ist. Die Raumwinkelauflösung läßt sich unter Beibehaltung des Halbkugelradius auch durch eine Verringerung der aktiven Fläche pro Detektorelement (und folglich durch eine Erhöhung der Detektorelement-Flächendichte) steigern, wobei dieser Miniaturisierung durch die verwendeten Bondtechniken Grenzen gesetzt sind.

Nachfolgend wird die Erfindung unter Bezugnahme auf die Zeichnungen beschrieben, in denen:
- Fig. 1: eine Gesamt- und eine Detailansicht der Metallisierungsebene eines Detektorelements zeigt;
- Fig. 2: eine Ansicht des kettengebondeten Detektorarrays (links) und des Leiterbahnträgers (mitte) mit einem Arrayausschnitt sowie der flexiblen Anschlußfolie mit einem Schaltungsträger (rechts) zeigt;
- Fig. 3: eine vergrößerte Darstellung des Leiterbahnträgers zeigt;
- Fig. 4: eine perspektivischen Ansicht eines komplett montierten Detektormoduls gemäß des ersten Ausführungsbeispiels der Erfindung zeigt; und
- Fig. 5: eine Querschnittsansicht eines Detektormoduls gemäß eines zweiten Ausführungsbeispiels der Erfindung zeigt.

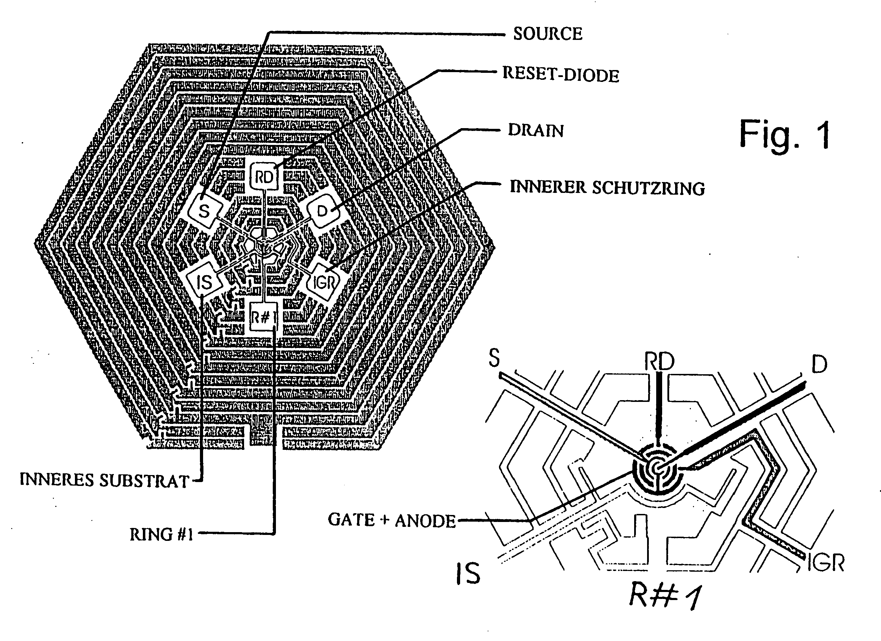

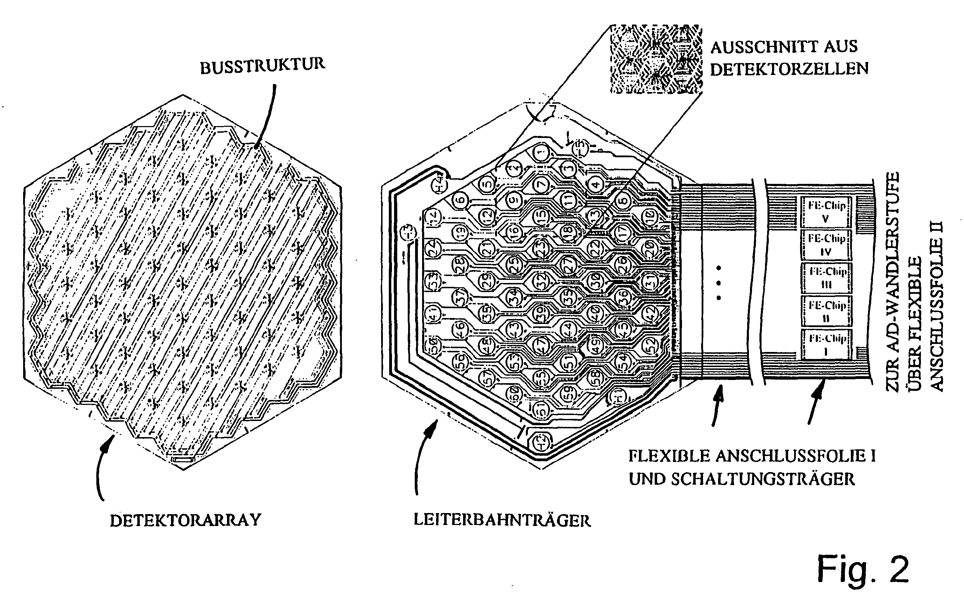

Der linke Teil von Figur 1 zeigt die Gesamtansicht der Metallisierungsebene eines einzelnen Detektorelements, und der rechte Teil von Figur 1 zeigt eine Detailansicht dieser Metallisierungsebene. Im Zentrum des Detektorelements befinden sich Drain- (D) sowie Gate- und Sourceanschlüsse (S) des monolithisch integrierten Feldeffekttransistors (Single-Sided Junction FET: SSJFET). Ein innerer Schutzring (IGR) und ein Substratanschluß (IS) trennen den Transistor räumlich von seiner Umgebung ab. Die schattiert dargestellten Metallstreifen stellen die Elektroden der darunterliegenden, geschlossenen, p-dotierten Wannen des Driftbereiches dar. Durch eine spannungsteilende Widerstands-Kette (Zick-Zack-Struktur) werden die Streifenpotentiale eingestellt. Diese Streifenpotentiale steigen von etwa -10 V mit zunehmendem Radius an. Ein sechseckiges Detektorarray hat vorzugsweise 61 dieser Detektorelemente, wobei diese 61 Detektorelemente von einer waabenförmigen Metallisierung (siehe Figur 2) umschlossen sind, mittels derer die einzelnen Detektorelemente mit der höchsten Sperrspannung versorgt werden. Die Substratrückseite der einzelnen Detektorelemente ist ebenfalls vorgespannt und bildet das Eintrittsfenster für die nachzuweisenden Photonen.

Figur 2 zeigt den Aufbau eines Detektormoduls mit 61 Detektorelementen und die entsprechende Anordnung der Anschlüsse der Detektorelemente. Im linken Teil von Figur 2 ist die Anordnung der einzelnen Detektorelemente zu einem Detektorarray (der Übersichtlichkeit halber ist nur die Metallisierungsebene des Zellenkerns mit Bondflächen dargestellt), im mittleren Teil ein Leiterbahnträger, der im zusammengebauten Zustand über dem Detektorarray angeordnet ist, und im rechten Teil eine flexible Anschlußfolie mit einem Schaltungsträger dargestellt. Die zu erreichende Deckungsübereinstimmung soll in Figur 2 durch den Detektorausschnitt gezeigt werden, dem zu entnehmen ist, daß sich die Bohrungen in dem Leiterbahnträger im zusammengebauten Zustand etwa über den Detektorelementen befinden. Wie im linken Teil von Figur 2 schematisch dargestellt, sind vier der jeweils sechs Anschlüsse (Pads) eines Detektorelements mit Hilfe von einfachen Kettenbondverbindungen an eine äußere, an den Außenkanten des Detektorarrays verlaufende Busstruktur angeschlossen. Dabei liegen die Anschlüsse RD und IS (siehe im linken Teil von Figur 1) auf einem gemeinsamen Potential. Die Bussignale sowie die beiden übrigen Anschlüsse R#1 und S (siehe linker Teil von Figur 1) werden über Bonddrahtverbindungen durch insgesamt 66 Bohrungen, deren Durchmesser etwa 1,25 mm beträgt, mit Endkontaktpunkten von jeweiligen Leiterbahnen verbunden, die auf dem keramischen Leiterbahnträger (mittlerer Teil von Figur 2) vorgesehen sind. Dabei werden die Anschlüsse R#1 und S von jedem Detektorelement durch die jeweils über dem Detektorelement liegende Bohrung geführt und mit den zugehörigen Kontaktpunkten der Leiterbahnen verbunden. Alle Leiterbahnen auf dem Leiterbahnträger münden an einer der sechs Kanten des Leiterbahnträgers (in Figur 2 ist es die rechte Kante des Leiterbahnträgers) und werden durch Drahtverbindungen direkt oder über eine flexible Anschlußfolie mit fünf integrierten Schaltungen (Front-End-Chips), die jeweils 12 Analogkanäle haben, gekoppelt (siehe rechter Teil von Figur 2), wo die Meßsignale verarbeitet werden. Neben den aktiven Komponenten können sich auf dem Schaltungsträger auch einige passive Komponenten befinden.

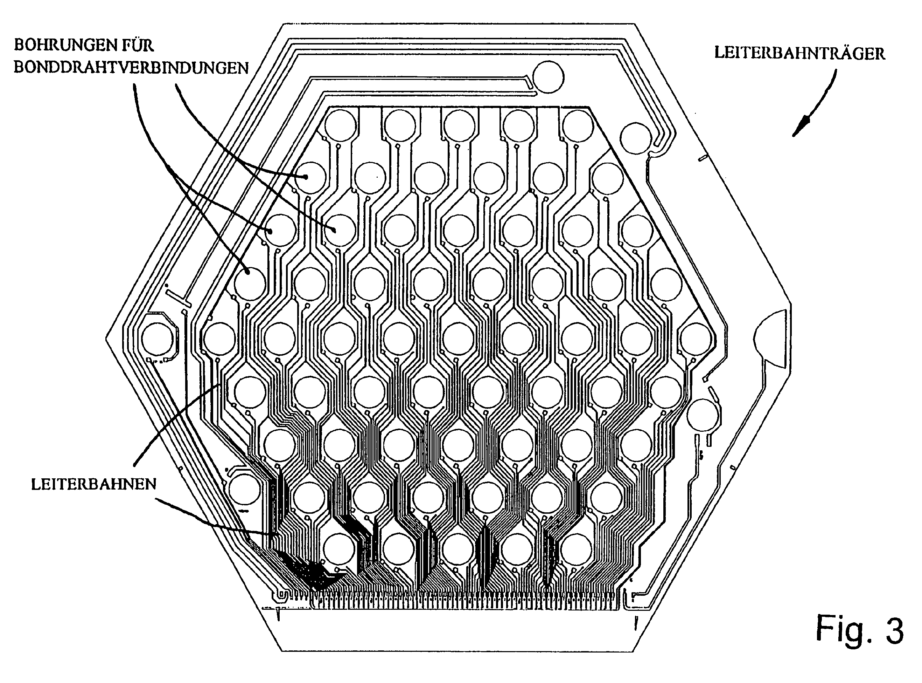

Figur 3 zeigt eine vergrößerte Darstellung des Leiterbahnträgers aus Figur 2, der im zusammengebauten Zustand des Detektormoduls über dem Detektorarray angeordnet ist. Deutlich zu sehen sind die Bohrungen zum Durchführen der beiden Bonddrähte von den beiden Detektoranschlüssen jedes Detektorelements. Die Bohrungen sind im zusammengesetzten Zustand des Detektormoduls jeweils über einem zugehörigen Detektorelement angeordnet. Direkt am Rand dieser Bohrungen sind auf der dem Detektorarray abgewandten Fläche des Leiterbahnträgers jeweils zwei Endkontakte (Ausgangssignalanschluß S und Versorgungsspannung R#1) von Leiterbahnen vorgesehen, an denen die von den Detektoranschlüssen ausgehenden und durch die zugehörigen Bohrungen herausgeführten Bonddrähte angebunden werden. Die Leiterbahnen verlaufen dann zwischen den anderen Bohrungen in Richtung auf die rechte Kante des Leiterbahnträgers, wo sie in einer Reihe von zweiten Endkontakten enden, an denen dann eine flexible Anschlußfolie oder ein starrer Schaltungsträger angeschlossen werden kann.

Die in Figur 3 gezeigte Anordnung bzw. der Verlauf der Leiterbahnen vom ersten Endkontakt zum zweiten Endkontakt ist genau so bestimmt, daß die einzelnen Leiterbahnen gegenüber in der Nähe verlaufender Leiterbahnen weitestgehend entkoppelt sind. Wie in Figur 3 weiter zu sehen ist, verlaufen zwischen den einzelnen signalführenden Leiterbahnen, die jeweils mit den Ausgangssignalanschlüssen S gekoppelt sind, sogenannten Abschirm-Leiterbahnen, die jeweils auf dem festen Potential R#1 liegen.

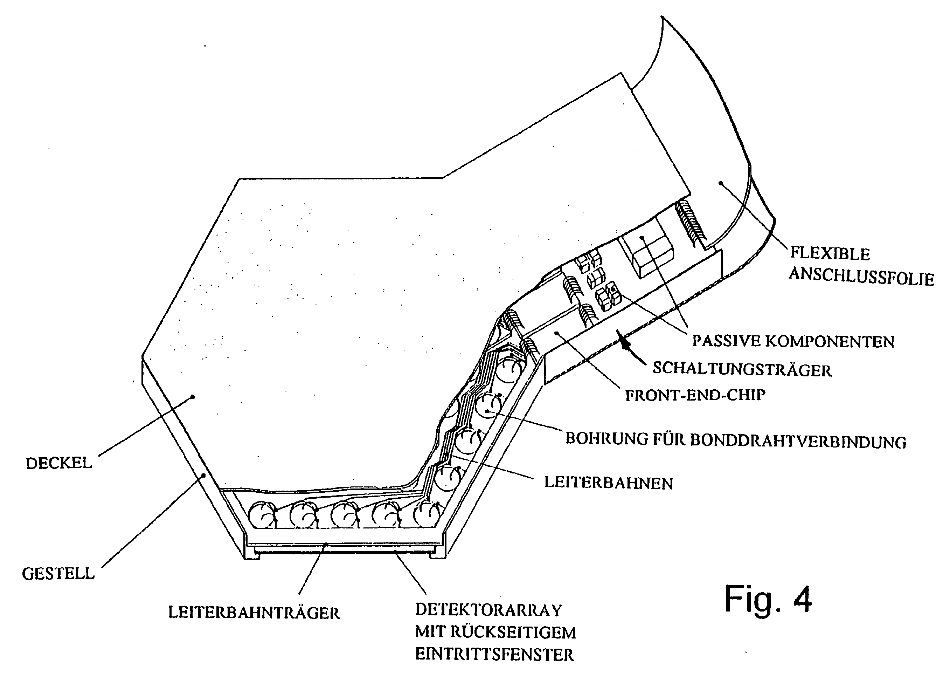

Figur 4 zeigt den mechanischen Gesamtaufbau des Detektormoduls gemäß dem ersten Ausführungsbeispiel der Erfindung. Dargestellt sind das aus den 61 Detektorelementen aufgebaute Detektorarray mit den in Figur 4 nach unten zeigenden Eintrittsfenstern und der über dem Detektorarray angeordnete Leiterbahnträger. Das Detektorarray und der Leiterbahnträger sind durch ein sechseckiges Gehäuse gehalten. Wie unter Bezugnahme auf Figur 2 erläutert, sind vier der sechs Anschlüsse von jedem der 61 Detektorelemente des Detektorarrays durch einfache Kettenbondverbindungen an eine äußere Busstruktur angeschlossen. Zum Zusammenbau des Detektormoduls wird zunächst das Detektorarray in das Gehäuse eingesetzt, mit diesem verklebt und kettenförmig gebondet. Anschließend wird die bereits bestückte Anordnung aus Leiterbahnträger und Schaltungsträger über dem Detektorarray in dem Gehäuse befestigt, wobei das Detektorarray und der Leiterbahnträger einen gleichmäßigen Abstand voneinander haben. Danach werden die für den Leiterbahnträgeranschluß vorgesehenen Bonddrähte durch die Bohrungen geführt und mit den beiden freien Anschlüssen der einzelnen Detektorelemente verbunden. An dieser Stelle werden die Vorteile der Erfindung besonders deutlich, da gut erkennbar ist, daß von den sechs Anschlüssen nur zwei Anschlüsse durch die Bohrungen des Leiterbahnträgers kontaktiert werden müssen. Die übrigen vier Anschlüsse jedes Detektorelements werden durch einfache Kettenbondverbindungen angeschlossen, was mechanisch unkritisch ist, da bei diesem Herstellungsschritte die obere Kontaktfläche des Detektorarrays freiliegt.

Bei der in Figur 4 gezeigten Ausgestaltung des Detektormoduls sind die Front-End-Chips und weitere passive Komponenten auf einem Schaltungsträger vorgesehen, der durch Drahtverbindungen direkt mit dem Leiterbahnträger verbunden ist, sofern die Verbindungsleitungen und die Schaltung nicht gemeinsam auf einem gemeinsamen Träger realisiert werden.

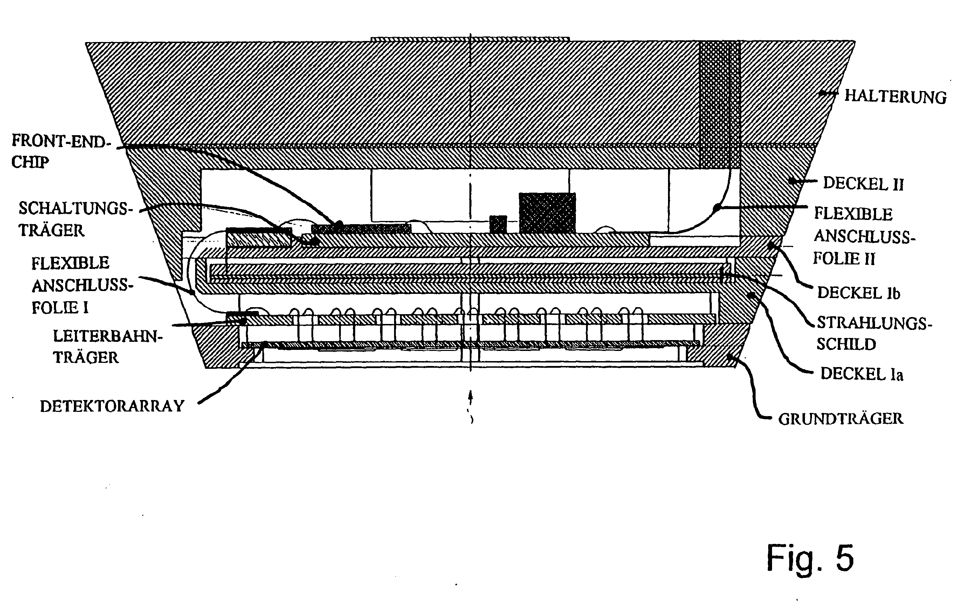

Eine sehr viel kompaktere Bauweise des Detektormoduls ist in Figur 5 dargestellt, in der ein Querschnitt einer alternativen Ausgestaltung des Detektormoduls gezeigt ist. Wie in Figur 5 zu sehen ist, ist das gebondete Detektorarray mit den nach unten zeigenden Strahlungs-Eintrittsfenstern in ein sechseckiges Gehäuse (bzw. in den Grundträger) eingesetzt und mit diesem verklebt. Direkt über dem Detektorarray (und von diesem gleichmäßig beabstandet) ist der Leiterbahnträger in das Gehäuse eingesetzt. In dieser Querschnittsansicht sind die in dem Leiterbahnträger vorgesehenen Bohrungen zu sehen, durch die für jedes Detektorelement die beiden Bonddrähten geführt sind, mittels derer die beiden Anschlüsse von dem jeweiligen Detektorelement mit zugehörigen Leiterbahnen auf dem Leiterbahnträger verbunden sind. Wie in Figuren 2, 3 und 4 zu sehen, enden auch bei der in Figur 5 gezeigten Ausgestaltung die auf dem Leiterbahnträger vorgesehenen Leiterbahnen an einer Kante des Leiterbahnträgers und sind an ihren Endpunkten bzw. Endkontakten mit einer flexiblen Anschlußfolie I verbunden. Die gegenüberliegenden Kontakte der Anschlußfolie I sind mit einem separaten Schaltungsträger verbunden, auf dem die gesamte analoge Signalverarbeitungselektronik vorgesehen ist. Die auf dem Schaltungsträger vorgesehenen Komponenten sind allgemein relativ strahlungsempfindlich und müssen daher abgeschirmt werden. Das wird bei der in Figur 5 gezeigten Ausgestaltung dadurch erreicht, daß über dem bereits im Gehäuse befestigten Leiterbahnträger ein Strahlungsschild vorgesehen ist, über dem der mit der Signalverarbeitungselektronik versehene Schaltungsträger angeordnet ist. Wie in Figur 5 deutlich zu sehen ist, wird die flexible Anschlußfolie I von dem Leiterbahnträger ausgehend seitlich durch einen Spalt an dem Strahlungsschild vorbei zu dem Schaltungsträger geführt. Die Ausgangssignale vom Schaltungsträger werden dann durch eine zweite flexibel Anschlußfolie II durch den über dem Schaltungsträger vorgesehenen Deckel II des Detektormoduls nach draußen geführt. Diese zweite Anschlußfolie II dient zur Kopplung des Detektormoduls mit einem A/D-Wandler-Modul, der digitalen Signalverarbeitungselektronik und einem Computer, der die erfaßten und vorverarbeiten Meßsignale weiterverarbeitet. Im konkreten Beispiel der Holographie wird nachfolgend ein Hologramm der atomaren Struktur der untersuchten Materialprobe auf einem Bildschirm darstellt.

Nicht nur aus Gründen der besseren Wärmeabfuhr besteht das Gehäuse des Detektormoduls zum wesentlichen Teil aus Graphit. Auch gestattet die niederenergetische Lage der Kohlenstofffluoreszenz eine Ausdehnung des empfindlichen Energiebereichs bis auf Werte um etwa 300 eV. Weiterhin sprechen auch formgebungstechnische Gesichtspunkte für die Auswahl von Graphit, da sich Graphit aufgrund seiner Feinkörnigkeit mit geringen Fertigungstoleranzen von unter 50 µm bearbeiten läßt. Wahlweise können verschiedene Teile des Gehäuses, wie zum Beispiel der Grundträger oder die Deckel Ia und Ib, auch aus Aluminium oder anderen Metallen oder auch technischen Keramiken bestehen, wie Aluminiumoxid oder Aluminiumnitrid (AlN).

Nicht alle Photonen werden im Siliziumvolumen des Detektorarrays absorbiert. Stattdessen wächst die Rate transmittierter Photonen mit zunehmender Photonenenergie progressiv an. Bei einem geschichteten Modulaufbau, wie er in Figur 5 gezeigt ist, kann die signalverarbeitende Elektronik durch diese Strahlung geschädigt und das Modul somit außer Funktion gesetzt werden. Ausfälle durch Strahlungsschäden lassen sich durch Einbettung des oben erwähnten Strahlungsschildes oberhalb des Detektorarrays verhindern. Dort absorbierte Photonen regen die Abschirmmaterialien zur Fluoreszenzstrahlung an, die sich dem eigentlich nachzuweisenden Energiespektrum aus der Probe überlagert. Als geeignete Strahlungsschildmaterialien sind chemisch stabile Materialien mit Atomen hoher Kernladungszahl geeignet, wie zum Beispiel Tantal oder Wolfram, um die Strahlenbelastung der Elektronik über die Detektorlebensdauer unterhalb von 1 krad zu halten. Zwischen dieser ersten Schicht (zum Beispiel aus Tantal oder Wolfram) und dem Detektorarray kann eine zweite Schicht aus einem geeigneten Material mit Atomen mittlerer Kernladungszahl, wie beispielsweise Titan, Vanadium oder Chrom vorgesehen sein, um die unerwünschte Fluoreszenz des Materials der ersten Schicht nach Absorptionsprozessen im Strahlungsschild zu absorbieren und vom Eintritt in das Detektorarray abzuhalten (im Fall von Tantal die Tantal-Fluoreszenz). Außerdem kann zwischen dieser zweiten Schicht und dem Detektorarray eine dritte Schicht aus einem geeigneten Material mit Atomen niedriger Kernladungszahl, wie zum Beispiel Aluminium, vorgesehen sein, um wiederum die Fluoreszenz des Materials der zweiten Schicht von dem Detektorarray fernzuhalten (im Fall Titan die Titan-Fluoreszenz). Die Fluoreszenz dieses dritten Materials i.a. hinreichend vom Kohlenstoff des Graphits absorbiert, aus dem der Deckel gebildet ist (siehe Figur 5). In der in Figur 5 dargestellten Ausgestaltung des Detektormoduls besteht das Strahlungsschild aus Tantal mit einer Dicke von mehr als 300 µm, Titan mit einer Dicke von mehr als 50 µm und Aluminium mit einer Dicke von mehr als 50 µm. Aufgrund der großen Fläche des Strahlungsschildes ist eine thermische Entkopplung zwischen Strahlungsschild und dem darüberliegenden Graphit-Deckel notwendig. Aus diesem Grunde wird der in Figur 5 materiallos dargestellte Bereich zwischen dem Strahlungsschild und dem Graphit-Deckel vorzugsweise mit einem Material geringer Wärmeleitfähigkeit ausgefüllt werden, wie beispielsweise mit Polymeren.

Die in Figur 5 dargestellte Ausführung des Detektormoduls eignet sich besonders für die eingangs erwähnte halbkugelförmige Anordnung (vorzugsweise die gekappte Ikosaeder-Struktur der C₆₀-Fullerene) um die Materialprobe angeordnet werden. Hierfür ist ein spezieller Rahmen erforderlich, der aus Gründen der besseren Wärmeleitfähigkeit und Abschirmung gegen äußere elektromagnetischen Felder und Strahlung aus Aluminium hergestellt ist. Die Halterung in Figur 5 bildet das Grundelement dieses Rahmens. Auf diese Weise können die einzelnen Detektormodule im Bedarfsfall einfach und schnell ausgetauscht werden. Durch Verwendung von identischen, vorzugsweise sechseckigen, Detektormodulen können außerdem die Herstellungskosten dieser Module gering gehalten werden.

## Patentansprüche

1. Detektormodul zur Röntgenstrahlungsmessung, mit
- einem Detektorarray, das eine erste, einer Strahlungsquelle zugewandte Fläche, die mit einer Vielzahl von Detektorelementen versehen ist, und eine zweite, der Strahlungsfläche abgewandte Fläche aufweist; und
- einem Leiterbahnträger, der beabstandet von der zweiten Fläche des Detektorarrays angeordnet und mit Leiterbahnen versehen ist;
- wobei erste Anschlüsse der Detektorelemente, die sich an der zweiten Fläche des Detektorarrays befinden, mit Hilfe von Bonddrähten mit den Leiterbahnen verbunden sind;
- wobei die Bonddrähte von den ersten Anschlüssen der Detektorelemente durch Bohrungen in dem Leiterbahnträger auf die dem Detektorarray abgewandte Seite des Leiterbahnträgers geführt sind, um mit den Leiterbahnen verbunden zu werden, die an der dem Detektorarray abgewandten Fläche des Leiterbahnträgers ausgebildet sind;
- wobei in dem Leiterbahnträger für jedes Detektorelement eine Bohrung vorgesehen ist; und
- wobei die Leiterbahnen zu einer Signalverarbeitungselektronik geführt sind, um die von den einzelnen Detektorelementen ausgehenden Signale zu verarbeiten.

2. Detektormodul nach Anspruch 1, bei dem die Detektorelemente mit einer Verstärker-Elektronik integriert sind.

3. Detektormodul nach Anspruch 1, bei dem die Detektorelemente hochempfindliche Driftdetektorzellen sind, die monolithisch mit Feldeffekttransistoren integriert sind.

4. Detektormodul nach einem der vorhergehenden Ansprüche, bei dem zweite Anschlüsse der Detektorelemente durch einfache Kettenbondverbindungen an einer auf dem Detektorarray vorgesehene Busstruktur angeschlossen sind.

5. Detektormodul nach Anspruch 4, bei dem die Busstruktur an den Außenkanten des Detektorarrays vorgesehen ist und die Busleitungen der Busstruktur durch Bonddrähte mit auf dem Leiterbahnträger ausgebildeten Leiterbahnen verbunden sind.

6. Detektormodul nach einem der vorhergehenden Ansprüche, bei dem das Detektorarray zusammen mit dem Leiterbahnträger in einem Gehäuse montiert ist.

7. Detektormodul nach Anspruch 6, bei dem das Gehäuse aus einem Material mit hoher Wärmeleitfähigkeit und geringem Röntgen-Fluoreszenzvermögen hergestellt ist.

8. Detektormodul nach Anspruch 6 oder 7, bei dem das Gehäuse aus Graphit hergestellt ist.

9. Detektormodul nach einem der Ansprüche 6 bis 8, bei dem die Signalverarbeitungselektronik ebenfalls in dem Gehäuse vorgesehen ist.

10. Detektormodul nach einem der vorhergehenden Ansprüche, bei dem die Signalverarbeitungselektronik auf einem Schaltungsträger vorgesehen ist, der an der dem Detektorarray abgewandten Seite des Leiterbahnträgers angeordnet ist.

11. Detektormodul nach einem der vorhergehenden Ansprüche, bei dem die Signalverarbeitungselektronik durch ein Strahlungsschild gegenüber der Strahlungsquelle abgeschirmt ist.

12. Detektormodul nach Anspruch 11, bei dem das Strahlungsschild zwischen dem Leiterbahnträger und der Signalverarbeitungselektronik vorgesehen ist.

13. Detektormodul nach Anspruch 11 oder 12, bei dem das Strahlungsschild eine erste Schicht aus einem chemisch stabilen Material mit Atomen hoher Kernladungszahl, wie beispielsweise Tantal oder Wolfram, aufweist.

14. Detektormodul nach Anspruch 13, bei dem die erste Schicht des Strahlungsschildes eine Dicke von mehr als 300 µm hat.

15. Detektormodul nach Anspruch 13 oder 14, bei dem an der der Strahlungsquelle zugewandten Seite der ersten Schicht des Strahlungsschildes eine zweite Schicht aus einem Material mit Atomen mittlerer Kernladungszahl vorgesehen ist, wie beispielsweise Titan, Vanadium oder Chrom.

16. Detektormodul nach Anspruch 15, bei dem die zweite Schicht des Strahlungsschildes eine Dicke von mehr als 50 µm hat.

17. Detektormodul nach Anspruch 15 oder 16, bei dem an der der Strahlungsquelle zugewandten Seite der zweiten Schicht des Strahlungsschildes eine dritte Schicht aus einem Material mit Atomen niedriger Kernladungszahl vorgesehen ist, wie beispielsweise Aluminium.

18. Detektormodul nach einem der vorhergehenden Ansprüche, bei dem der Leiterbahnträger mittels einer flexiblen Anschlußfolie (I) mit dem Schaltungsträger gekoppelt ist.

19. Detektormodul nach einem der vorhergehenden Ansprüche, bei dem der Schaltungsträger mittels einer flexiblen Anschlußfolie (II) mit der Signalverarbeitungselektronik gekoppelt ist.

20. Detektormodul nach einem der vorhergehenden Ansprüche, das eine sechseckige oder fünfeckige oder viereckige Form hat.

21. Detektormodul nach einem der vorhergehenden Ansprüche, bei dem die Kontaktierung zwischen dem Detektorarray und dem Leiterbahnträger mittels Flip-Chip-Kontaktierung ausgeführt ist.

22. Detektormodul nach einem der vorhergehenden Ansprüche, bei dem zwischen dem mechanisch stabilen Trägermaterial des Leiterbahnträgers und der signalführenden Metallisierungsebene der Leiterbahnen eine Zwischenschicht vorgesehen ist, deren Dielektrizitätskonstante deutlich kleiner ist als die des Trägermaterials.

23. Detektormodul nach Anspruch 22, bei dem die Zwischenschicht eine Dicke hat, die etwa gleich der Breite von einer signalführenden Leiterbahn entspricht.

24. Detektormodul nach Anspruch 22 oder 23, bei dem als Material für die Zwischenschicht Benzocyclobutene oder Polyphenylquinoxaline verwendet werden.

25. Detektormodul nach einem der Ansprüche 22 bis 24, bei dem in der Metallisierungsebene zwischen den signalführenden Leiterbahnen Abschirm-Leiterbahnen vorgesehen sind und wobei an gleicher Stelle auch in einer zweiten Metallisierungsebene zwischen dem stabilen Trägermaterial des Leiterbahnträgers und der dielektrischen Zwischenschicht weitere Abschirm-Leiterbahnen vorgesehen sind.

26. Röntgendetektorsystem, mit
- einer Anzahl von Detektormodulen gemäß einem der Ansprüche 1 bis 25;
- einem Rahmen zur Halterung der Anzahl von Detektormodulen auf einer im wesentlichen halbkugelförmigen Fläche um eine zu untersuchende Materialprobe herum;
- wobei die im wesentlichen halbkugelförmigen Fläche durch eine gekappte Ikosaeder-Struktur gebildet ist.

## Claims

1. Detector module for x-radiation measurement, comprising
- a detector array which has a first surface facing a radiation source and being provided with a number of detector elements, and a second surface facing away from the radiation source; and
- a conductor track carrier being arranged at a distance from the second surface of the detector array and being provided with conductor tracks;
- wherein first terminals of the detector elements located on the second surface of the detector array are connected to the conductor tracks by means of bonding wires;
- wherein the bonding wires are guided from the first terminals of the detector elements through bores in the conductor track carrier onto the side of the conductor track carrier facing away from the detector array to be connected to the conductor tracks which are provided on the surface of the conductor track carrier facing away from the detector array;
- wherein a bore is provided in the conductor track carrier for each detector element; and
- wherein the conductor tracks being guided to signal-processing electronics to process the signals coming from the individual detector elements.

2. Detector module according to claim 1, wherein the detector elements are integrated with amplifier electronics.

3. Detector module according to claim 1, wherein the detector elements are highly sensitive drift detector cells which are monolithically integrated with field effect transistors.

4. Detector module according to one of the previous claims, wherein second terminals of the detector elements are connected by simple chain bonding connections to a bus structure provided on the detector array.

5. Detector module according to claim 4, wherein the bus structure is provided at the external edges of the detector array and the bus lines of the bus structure are connected by bonding wires to conductor tracks provided on the conductor track carrier.

6. Detector module according to one of the previous claims, wherein the detector array together with the conductor track carrier is mounted within a housing.

7. Detector module according to claim 6, wherein the housing is made of a material with high thermal conductivity and low X-ray fluorescence capacity.

8. Detector module according to claim 6 or 7, wherein the housing is made of graphite.

9. Detector module according to one of claims 6 to 8, wherein the signal-processing electronics are also provided within the housing.

10. Detector module according to one of the previous claims, wherein the signal-processing electronics are provided on a circuit support which is arranged on the side of the conductor track carrier facing away from the detector array.

11. Detector module according to one of the previous claims, wherein the signal-processing electronics are shielded against the radiation source by a radiation shield.

12. Detector module according to claim 11, wherein the radiation shield is provided between the conductor track carrier and the signal-processing electronics.

13. Detector module according to claim 11 or 12, wherein the radiation shield has a first layer of a chemically stable material with atoms of high atomic number, such as for example tantalum or tungsten.

14. Detector module according to claim 13, wherein the first layer of the radiation shield has a thickness of more than 300 µm.

15. Detector module according to claim 13 or 14, wherein, at the side of the first layer of the radiation shield facing the radiation source, a second layer of a material with atoms of medium atomic number is provided, such as for example titanium, vanadium or chromium.

16. Detector module according to claim 15, wherein the second layer of the radiation shield has a thickness of more than 50 µm.

17. Detector module according to claim 15 or 16, in which, at the side of the second layer of the radiation shield facing the radiation source, a third layer of a material with atoms of low atomic number is provided, such as for example aluminium.

18. Detector module according to one of the previous claims, wherein the conductor track carrier is coupled with the circuit support by means of a flexible connection film (I).

19. Detector module according to one of the previous claims, wherein the conductor track carrier is coupled with the signal-processing electronics by means of a flexible connection film (II).

20. Detector module according to one of the previous claims, which has a hexagonal or pentagonal or quadrangular shape.

21. Detector module according to one of the previous claims, wherein contact between the detector array and the conductor track carrier is achieved by means of flip-chip contact.

22. Detector module according to one of the previous claims, wherein an intermediate layer the dielectric constant of which is clearly less than that of the carrier material is provided between the mechanically stable carrier material of the conductor track carrier and the signal-carrying metallization plane of the conductor tracks.

23. Detector module according to claim 22, wherein the intermediate layer has a thickness which corresponds to approximately the width of a signal-carrying conductor track.

24. Detector module according to claim 22 or 23, wherein benzocyclobutenes or polyphenylquinoxalines are used as material for the intermediate layer.

25. Detector module according to one of claims 22 to 24, wherein shielding conductor tracks are provided in the metallization plan between the signal-carrying conductor tracks, and wherein additional shielding conductor tracks are also provided at the same point in a second metallization plane between the stable carrier material of the conductor track carrier and the dielectric intermediate layer.

26. X-ray detector system, comprising
- a number of detector modules according to one of claims 1 to 25;
- a frame for holding the number of detector modules on an essentially hemispherical surface around a material sample to be examined;
- wherein the essentially hemispherical surface being formed by a capped icosahedron structure.

## Revendications

1. Module détecteur pour la mesure de rayonnement X, comprenant
- un dispositif détecteur, qui présente une première surface tournée vers une source de rayonnement, laquelle est dotée d'une pluralité d'éléments détecteurs, et une seconde surface opposée à la surface de rayonnement ; et
- un support de piste conductrice, qui est disposé sur la seconde surface du dispositif détecteur et est espacé de celle-ci et est doté de pistes conductrices ;
- des premiers branchements des éléments détecteurs, qui se trouvent sur une seconde surface du dispositif détecteur, étant reliés à l'aide de fils de bonding aux pistes conductrices ;
- les fils de bonding étant guidés depuis les premiers branchements des éléments détecteurs par des perçages dans le support de piste conductrice vers le côté, opposé au dispositif détecteur, du support de piste conductrice, afin d'être reliés aux pistes conductrices, qui sont réalisées sur la surface, opposée au dispositif détecteur, du support de piste conductrice ;
- un perçage étant prévu dans le support de piste conductrice pour chaque élément détecteur ; et
- les pistes conductrices étant guidées vers une électronique de traitement de signal, afin de traiter les signaux partant des éléments détecteurs individuels.

2. Module détecteur selon la revendication 1, dans lequel les éléments détecteurs sont intégrés avec une électronique d'amplificateur.

3. Module détecteur selon la revendication 1, dans lequel les éléments détecteurs sont des cellules de détecteur de dérive ultrasensibles, lesquelles sont intégrées de façon monolithe avec des transistors à effet de champ.

4. Module détecteur selon l'une quelconque des revendications précédentes, dans lequel des seconds branchements des éléments détecteurs sont raccordés par de simples liaisons de bonding en chaîne sur une structure de bus prévue sur le dispositif détecteur.

5. Module détecteur selon la revendication 1, dans lequel la structure de bus est prévue sur les arêtes extérieures du dispositif détecteur et les lignes de bus de la structure de bus sont reliées par des fils de bonding à des pistes conductrices réalisées sur le support de piste conductrice.

6. Module détecteur selon l'une quelconque des revendications précédentes, dans lequel le dispositif détecteur est monté conjointement avec le support de pièce conductrice dans un boîtier.

7. Module détecteur selon la revendication 6, dans lequel le boîtier est fabriqué à base d'un matériau présentant une conductivité thermique élevée et un faible pouvoir de fluorescence aux rayons X.

8. Module détecteur selon la revendication 6 ou 7, dans lequel le boîtier est fabriqué en graphite.

9. Module détecteur selon l'une quelconque des revendications 6 à 8, dans lequel l'électronique de traitement de signal est prévue également dans le boîtier.

10. Module détecteur selon l'une quelconque des revendications précédentes, dans lequel l'électronique de traitement de signal est prévue sur un support de circuit, lequel est disposé sur le côté, opposé au dispositif détecteur, du support de piste conductrice.

11. Module détecteur selon l'une quelconque des revendications précédentes, dans lequel l'électronique de traitement de signal est protégée par un bouclier de rayonnement par rapport à la source de rayonnement.

12. Module détecteur selon la revendication 11, dans lequel le bouclier de rayonnement est prévu entre le support de piste conductrice et l'électronique de traitement de signal.

13. Module détecteur selon la revendication 11 ou 12, dans lequel le bouclier de rayonnement présente une première couche à base d'un matériau chimiquement instable avec des atomes de numéro atomique Z élevé, par exemple le tantale ou le tungstène.

14. Module détecteur selon la revendication 13, dans lequel la première couche du bouclier de rayonnement a une épaisseur supérieure à 300 µm.

15. Module détecteur selon la revendication 13 ou 14, dans lequel sur le côté, tourné vers la source de rayonnement, de la première couche du bouclier de rayonnement est prévue une seconde couche à base d'un matériau avec des atomes de numéro atomique Z moyen, par exemple le titane, le vanadium ou le chrome.

16. Module détecteur selon la revendication 15, dans lequel la seconde couche du bouclier de rayonnement présente une épaisseur supérieure à 50 µm.

17. Module détecteur selon la revendication 15 ou 16, dans lequel sur le côté, tourné vers la source de rayonnement, de la seconde couche du bouclier de rayonnement est prévue une troisième couche à base d'un matériau avec des atomes de numéro atomique Z faible, par exemple l'aluminium.

18. Module détecteur selon l'une quelconque des revendications précédentes, dans lequel le support de piste conductrice est couplé au moyen d'un film de raccordement (I) flexible au support de circuit.

19. Module détecteur selon l'une quelconque des revendications précédentes, dans lequel le support de circuit est couplé au moyen d'un film de raccordement (II) flexible à l'électronique de traitement de signal.

20. Module détecteur selon l'une quelconque des revendications précédentes, qui a une forme hexagonale ou pentagonale ou carrée.

21. Module détecteur selon l'une quelconque des revendications précédentes, dans lequel la mise en contact entre le dispositif détecteur et le support de piste conductrice est réalisée au moyen de contact par puce à protubérances Flip-Chip.

22. Module détecteur selon l'une quelconque des revendications précédentes, dans lequel entre le matériau mécaniquement stable du support de piste conductrice et le plan de métallisation, véhiculant le signal, des pistes conductrices est prévue une couche intermédiaire, dont la constante diélectrique est nettement inférieure à celle du matériau support.

23. Module détecteur selon la revendication 22, dans lequel la couche intermédiaire a une épaisseur qui correspond à peu près à la largeur d'une piste conductrice véhiculant le signal.

24. Module détecteur selon la revendication 22 ou 23, dans lequel des benzocyclobutènes ou des polyphényl-quinoxalines sont utilisés comme matériau pour la couche intermédiaire.

25. Module détecteur selon l'une quelconque des revendications 22 à 24, dans lequel des pistes conductrices de blindage sont prévues dans le plan de métallisation entre les pistes conductrices véhiculant le signal et d'autres pistes conductrices de blindage sont prévues au même endroit également dans un second plan de métallisation entre le matériau support stable du support de piste conductrice et la couche intermédiaire diélectrique.

26. Système détecteur de rayons X, comprenant :
- un certain nombre de modules détecteurs selon l'une quelconque des revendications 1 à 25 ;
- un cadre pour la fixation du nombre de modules détecteurs sur une surface sensiblement hémisphérique sur un échantillon de matériau à examiner,
- la surface sensiblement hémisphérique étant formée par une structure d'icosaèdre raccourcie.
